# FASCICULE DE BREVET EUROPEEN

(11) **EP 0 595 734 B1**
(45) Date de publication et mention de la délivrance du brevet: **29.12.1999**
(21) Numéro de dépôt: 93420414.0
(22) Date de dépôt: 25.10.1993
(51) Int. Cl.: G06F 1/025, H03K 23/68

(54) **Multiplexeur recevant en entrée une pluralité de signaux identiques mais déphasés**
Multiplexer, an dessen Eingang mehrere identische Signale verschiedener Phasenlage anliegen
Multiplexer receiving at its input a plurality of identical signals differing only in phase

(30) Priorité: 30.10.1992 FR 9213432
(43) Date de publication de la demande: 04.05.1994
(73) Titulaire: STMicroelectronics S.A., 94250 Gentilly (FR)
(72) Inventeur: Lemaire, Frédéric, F-38120 Saint-Egreve (FR)
(74) Mandataire: de Beaumont, Michel

(56) Documents cités:
- EP-A- 0 475 862

## Description

La présente invention concerne les multiplexeurs et plus particulièrement un multiplexeur à 2^{q+1} signaux d'entrée déphasés les uns par rapport aux autres de 360°/2^{q+1}, sélectionnés successivement par ordre de retard de phase croissant.

Un multiplexeur recevant de tels signaux est particulièrement utile pour réaliser un diviseur rapide par ½ + 2^{m}, tel que celui décrit dans la demande de brevet français 2 666 706.

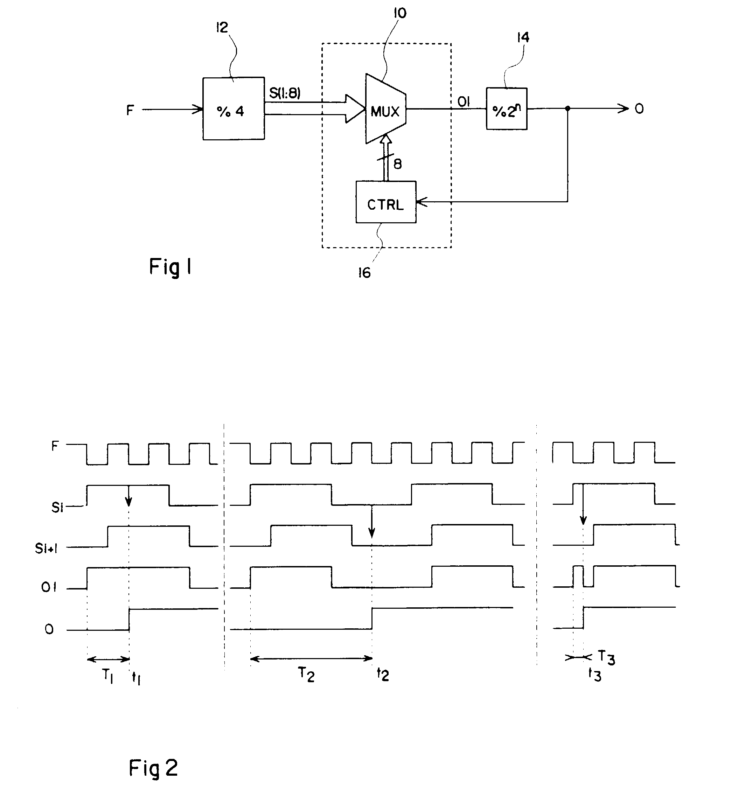

La figure 1 reprend schématiquement le diviseur par ½ + 2^{m} de la demande de brevet susmentionnée. Ce diviseur comprend un multiplexeur 10 recevant par exemple 8 signaux d'entrée S1 à S8 fournis par un compteur à 4 bits 12, dit de type Johnson, qui présente la particularité de fournir des signaux identiques mais déphasés les uns par rapport aux autres d'une valeur constante, dans ce cas 360°/8. Ce compteur 12 reçoit le signal F à diviser. La sortie O1 du multiplexeur 10 est fournie à un diviseur 14 par 2ⁿ dont la sortie fournit le signal O de sortie du circuit. Le signal O est en outre rebouclé sur un circuit de commande 16 du multiplexeur 10. Le circuit de commande 16 est prévu pour changer la sélection du multiplexeur 10 à chaque front déterminé du signal O. Le multiplexeur 10 est commandé pour fournir à chaque commutation successivement les signaux d'entrée par ordre de retard de phase croissant. On obtient, dans l'exemple de la figure 1, un diviseur par ½ + 2ⁿ⁺², particulièrement rapide.

Ci-après, on désigne par Si le signal courant sélectionné dans le multiplexeur 10, et par Si+1 le signal suivant à sélectionner (i ou i+1 = 1, 2... 8).

La figure 2 représente un chronogramme de signaux du circuit de la figure 1 dans trois situations différentes délimitées par deux traits mixtes verticaux. On a représenté le signal F à diviser ; des signaux Si et Si+1 ; le signal O de sortie du diviseur par ½ + 2^{m} présentant trois valeurs différentes de retard T₁, T₂, T₃ ; et le signal O1 de sortie du multiplexeur 10. Les signaux Si et Si+1 sont identiques et ont un rapport cyclique de 50 %. Le signal Si+1 est en retard de phase par rapport au signal Si d'une demi-période du signal F (ce qui correspond à 1/8 de période du signal Si ou Si+1, ou encore à 360°/8).

On a représenté à des instants t₁, t₂ et t₃ trois fronts montants du signal O qui entraînent chacun une commutation du multiplexeur 10 du signal Si vers le signal Si+1. Le but d'une commutation d'un signal au suivant est "d'avaler" une demi-période du signal F. C'est ce qui permet d'obtenir le terme ½ dans le taux de division ½ + 2^{m}.

Les commutations se produisent à des instants qui dépendent du retard introduit par le divisieur 14, le retard du circuit de commande étant négligé ici pour la clarté de l'exposé. Ce retard correspond au retard de commutation de n bascules si le diviseur 14 est un diviseur par 2ⁿ. Idéalement, les commutations se produisent à des instants analogues aux instants tl et t₂ où les signaux Si et Si+1 sont au même état logique. Dans ce cas, la phase en cours (état haut à l'instant t₁ et bas à l'instant t₂) du signal O1 se trouve prolongée d'une demi-période du signal F.

L'instant t₃ correspond à un instant de commutation à éviter. La commutation se produit alors que les signaux Si et Si+1 sont à des états logiques différents. Dans la figure, l'instant t₃ survient lorsque le signal Si est à l'état haut alors que le signal Si+1 n'est pas encore à l'état haut. Le signal O1 de sortie du multiplexeur 10 présente entre l'instant t₃ et le prochain front montant du signal Si+1, un état bas indésirable. Ainsi, le signal O1 présente un front supplémentaire entrainant un comptage erroné par le diviseur 14.

Dans une technologie donnée, on connaît approximativement le retard introduit dans le diviseur 14, et le circuit est conçu pour que les commutations du multiplexeur 10 se produisent lorsque le signal courant Si et le prochain signal à sélectionner Si+1 sont au même état. Toutefois, si la fréquence d'entrée F varie, l'instant de commutation glisse, par exemple, d'une situation correspondant à l'instant t₂ vers une mauvaise situation correspondant à l'instant t₃. Le diviseur de la figure 1 ne peut donc fonctionner que dans une plage de fréquence restreinte.

Un objet de la présente invention est de prévoir une structure de multiplexeur permettant d'élargir la plage de fréquence d'un diviseur du type de la figure 1.

Cet objet est atteint grâce à un multiplexeur à 2^{q+1} entrées recevant des signaux périodiques déphasés les uns par rapport aux autres, commandé de manière à commuter d'un signal d'entrée courant à un signal d'entrée suivant par l'activation d'un signal de commutation, le signal suivant étant en retard de phase par rapport au signal courant de 360°/2^{q+1}. Selon l'invention, des moyens sont prévus pour synchroniser le signal de commutation sur un front du signal d'entrée suivant.

Selon un mode de réalisation de la présente invention, le multiplexeur comprend : des premier et deuxième multiplexeurs recevant respectivement les 2^{q} signaux d'entrée de rang impair ; et les 2^{q} signaux d'entrée de rang pair ; un troisième multiplexeur recevant sur les première et deuxième entrées les signaux de sortie des premier et deuxième multiplexeurs respectivement, et fournissant le signal de sortie du multiplexeur à 2^{q+1} entrées ; un quatrième multiplexeur recevant sur des première et deuxième entrées les signaux de sortie des deuxième et premier multiplexeurs respectivement ; une bascule recevant sur une entrée de donnée ledit signal de commutation par l'intermédiaire d'un diviseur par 2, recevant sur son entrée d'horloge la sortie du quatrième multiplexeur, et fournissant le signal de sélection des troisième et quatrième multiplexeurs ; et des moyens de commande des premier et deuxième multiplexeurs commutant la sélection du premier multiplexeur à chaque activation de rang impair du signal de commutation et commutant la sélection du deuxième multiplexeur à chaque activation de rang pair du signal de commutation.

Ces objets, caractéristiques et avantages ainsi que d'autres de la présente invention seront exposés en détail dans la description suivante de modes de réalisation particuliers faite en relation avec les figures jointes parmi lesquelles :
la figure 1, précédemment décrite, représente un diviseur par ½ + 2^{m} classique ;
la figure 2 représente un chronogramme de signaux du circuit de la figure 1 ;
la figure 3 représente un mode de réalisation de multiplexeur selon la présente invention ;
la figure 4 représente des chronogrammes de signaux du multiplexeur de la figure 3 ; et
la figure 5 représente un circuit de commande du multiplexeur de la figure 3.

La présente invention vise une structure de multiplexeur à utiliser dans un diviseur du type de la figure 1, permettant d'assurer qu'une commutation d'un signal courant Si à un signal suivant à sélectionner Si+1 se produise toujours juste après une phase où les signaux Si et Si+1 sont à des états différents. Pour obtenir ce résultat, l'invention propose de synchroniser une commutation du multiplexeur sur l'un ou l'autre des fronts du signal suivant à sélectionner Si+1.

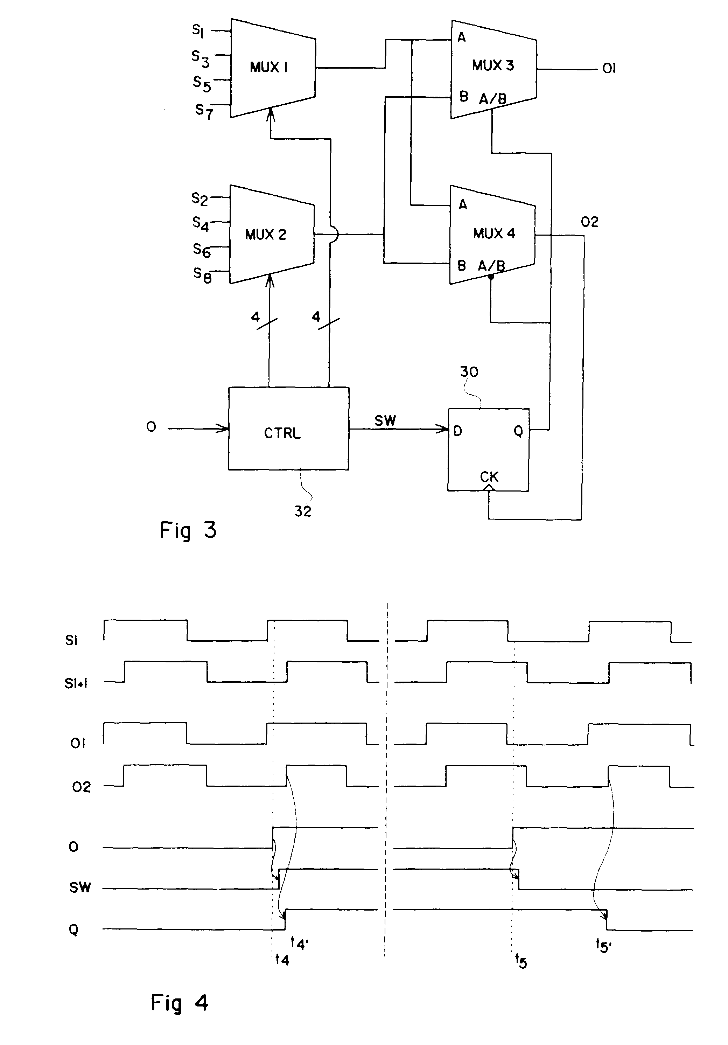

La figure 3 représente un mode de réalisation de multiplexeur selon l'invention recevant, par exemple, 8 signaux d'entrée S1 à S8. Ce multiplexeur correspond aux éléments entourés dans la figure 1 par un cadre en pointillés.

Ce multiplexeur comprend un premier multiplexeur MUX1 à quatre canaux recevant les signaux S de rang impair fournis par le compteur 12 et un deuxième multiplexeur MUX2 à quatre canaux recevant les signaux S de rang pair. Deux multiplexeurs à deux canaux MUX3 et MUX4 reçoivent chacun sur une entrée A la sortie du multiplexeur MUX1 et sur une entrée B la sortie du multiplexeur MUX2. La sortie Q d'une bascule 30 de type D sélectionne, par un état 1, le canal A du multiplexeur MUX3 et le canal B du multiplexeur MUX4. L'état O de la sortie Q sélectionne le canal B du multiplexeur MUX3 et le canal A du multiplexeur MUX4. La sortie du multiplexeur MUX3 constitue la sortie O1 du multiplexeur 10 de la figure 1. La sortie O2 du multiplexeur MUX4 est reliée à l'entrée d'horloge de la bascule 30. Les multiplexeurs MUX1 et MUX2 sont commandés par un circuit de commande 32 recevant en entrée le signal O de sortie du diviseur par ½ + 2^{m} et fournissant un signal SW à l'entrée de donnée de la bascule 30.

Le circuit de commande 32 commande les multiplexeurs MUX1 et MUX2 de la façon suivante.

Initialement, un signal Sj (j = 1...8) est sélectionné dans le multiplexeur MUX1 et un signal Sj+1 est sélectionné dans le multiplexeur MUX2. Lorsque survient un front descendant, par exemple, du signal O, le circuit de commande 32 sélectionne dans le multiplexeur MUX1 le signal Sj+2 et le signal Sj+1 reste sélectionné dans le multiplexeur MUX2. Au prochain front descendant du signal O, le circuit de commande 32 sélectionne le signal Sj+3 dans le multiplexeur MUX2 et le signal Sj+2 reste sélectionné dans le multiplexeur MUX1, et ainsi de suite. Ainsi, le multiplexeur MUX1 est commuté à chaque front descendant de rang impair, par exemple, du signal O et le multiplexeur MUX2 est commuté à chaque front descendant de rang pair.

En outre, à chaque front montant du signal O, le signal SW bascule. Le nouvel état du signal SW n'est transmis aux entrées de sélection des multiplexeurs MUX3 et MUX4 que si le signal O2 de sortie du multiplexeur MUX4 présente un front actif, par exemple montant. Alors, les signaux de sortie des multiplexeurs MUX3 et MUX4 sont intervertis.

Avec cette configuration, en choisissant l'état initial de la bascule 30 pour que le multiplexeur MUX1 ou MUX2 qui est commuté est celui dont la sortie est sélectionnée par le multiplexeur MUX4, on a sur la sortie O1, avant la survenue d'un front montant du signal O, le signal courant Si et sur la sortie O2 le signal suivant à sélectionner Si+1.

Le tableau ci-dessous illustre mieux ce fonctionnement à l'aide d'un exemple. La première colonne indique les états du signal O et les deuxième à cinquième colonnes indiquent respectivement des signaux S successifs transmis par les multiplexeurs MUX1 à MUX4.

| O | MUX1 | MUX2 | MUX3 (O1) | MUX4 (O2) |
|---|---|---|---|---|
| 0 | S1 | S2 | S1 | S2 |
| 1 | S1 | S2 | S2 | S1 |
| 0 | S3 | S2 | S2 | S3 |
| 1 | S3 | S2 | S3 | S2 |
| 0 | S3 | S4 | S3 | S4 |
| 1 | S3 | S4 | S4 | S3 |
| 0 | S5 | S4 | S4 | S5 |
| ... | ... | ... | ... | ... |

La figure 4 représente des chronogrammes de signaux du circuit de la figure 3 dans deux situations différentes représentées de part et d'autre d'un trait mixte vertical.

On a représenté le signal courant Si ; le prochain signal à sélectionner Si+1 ; le signal O1 de sortie du multiplexeur MUX3 ; le signal O2 de sortie du multiplexeur MUX4 ; le signal O de commutation (ou de sortie du diviseur par ½ + 2^{m}) ; le signal SW fourni par le circuit de commande 32 à la bascule 30 ; et le signal Q de sélection des multiplexeurs MUX3 et MUX4.

A la partie gauche de la figure 4, un front actif, par exemple montant, du signal O survient à un instant t₄ alors que le signal Si est à un état haut et le signal Si+1 à un état bas, ce qui correspond à une situation indésirable dans le circuit de la figure 1. Jusqu'à l'instant t₄, le signal O1 est égal au signal Si et le signal O2 est égal au signal Si+1 (dans le cas représenté, jusqu'à l'instant t₄, le signal Si est délivré par le multiplexeur MUX2 et le signal Si+1 par le multiplexeur MUX1).

Le signal SW bascule à un état haut légèrement après le front du signal O. Toutefois, le signal SW n'est transmis sur la sortie Q qu'au prochain front montant du signal O2 à un instant t₄'. Ainsi, la commutation du signal Si au signal Si+1 se produit à l'instant t₄' où les signaux Si et Si+1 sont au même état 1. Comme cela a été décrit précédemment, la commutation des multiplexeurs MUX1 et MUX2 n'est effectuée par le circuit de commande 32 qu'au prochain front descendant du signal O, et on ne commute alors que le multiplexeur MUX1 ou MUX2 dont la sortie est transmise par le multiplexeur MUX4.

A la partie droite de la figure 4, un front montant du signal O survient alors que le signal Si est à l'état bas et le signal Si+1 à l'état haut, ce qui correspond à l'autre situation indésirable du circuit de la figure 1. Le signal SW bascule à un état bas peu de temps après mais, comme dans le cas précédent, cet état n'est transmis à l'entrée de sélection des multiplexeurs MUX3 et MUX4 qu'au prochain front montant, à un instant t₅', du signal O2. L'instant t₅' correspond à l'instant t₄' précédemment décrit.

Ainsi, une commutation d'un signal courant Si à un signal suivant à sélectionner Si+1 se produit, quelque soit l'instant d'arrivée du front actif du signal O, juste après une phase où les signaux Si et Si+1 sont à des états différents. Bien entendu, la commutation se produit avec un léger retard correspondant au retard introduit par la bascule 30 et par la commutation des multiplexeurs MUX3 et MUX4. Ce retard reste, même si l'on travaille à la fréquence maximum autorisée par le compteur 12 (supposé réalisé dans la même technologie que le multiplexeur selon l'invention), inférieur à la durée de la phase suivant le front du signal O2, où les signaux Si et Si+1 sont au même état.

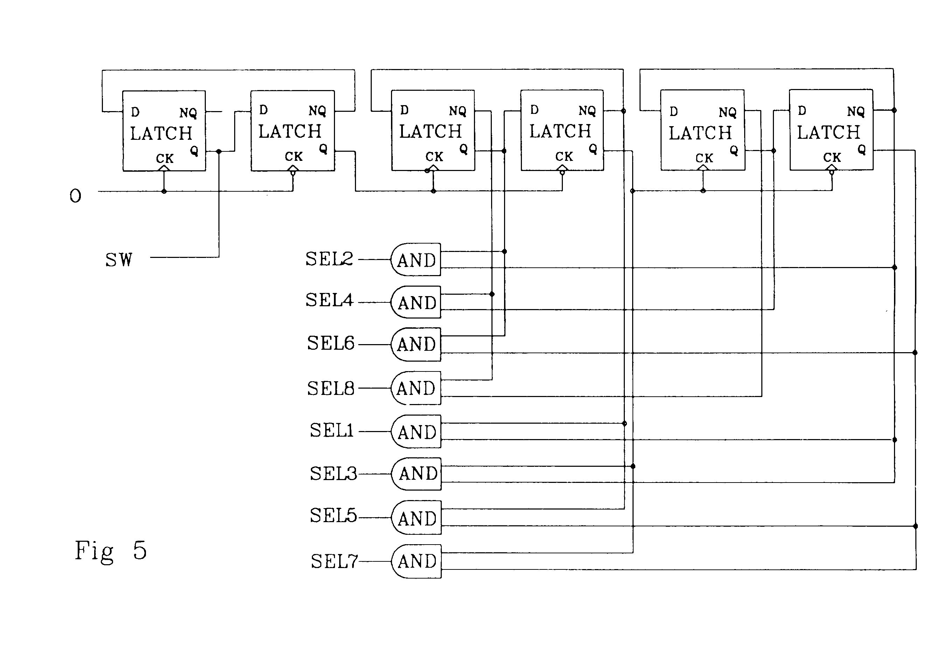

La figure 5 représente un mode de réalisation du circuit de commande 32 permettant d'obtenir les fonctions précédemment décrites, à savoir la sélection des signaux S dans les multiplexeurs MUX1 et MUX2 et la fourniture du signal SW. La figure 5 sera considérée comme incorporée dans la présente description. Ce circuit comprend trois diviseurs par 2 disposés en cascade et constitués chacun de manière connue par deux verrous (couramment désignés par le terme anglais "latch") rebouclés. Le signal O est fourni au premier diviseur par 2 et le signal SW est pris au niveau de la connexion du premier verrou au deuxième de ce diviseur. Ceci permet de réduire le délai entre le signal O et le signal SW à seulement le délai de transfert d'un verrou.

Les sorties des verrous des deux diviseurs suivants sont exploités par un circuit décodeur formé de portes ET (AND) dont chaque sortie SEL1 à SEL8 sélectionne dans le multiplexeur adéquat MUX1 ou MUX2 le signal correspondant S1 à S8 de la manière décrite.

De nombreuses variantes et modifications de la présente invention apparaîtront à l'homme du métier, notamment en ce qui concerne le choix des fronts actifs des signaux et la réalisation spécifique du circuit de commande 32 pour obtenir les fonctions décrites. L'homme du métier saura réaliser un multiplexeur selon l'invention à 2^{q+1} entrées.

## Revendications

1. Multiplexeur à 2^{q+1} entrées recevant des signaux périodiques (S1 à S2^{q+1}) déphasés les uns par rapport aux autres, commandé de manière à commuter d'un signal d'entrée courant (Si) à un signal d'entrée suivant (Si+1) par l'activation d'un signal de commutation (O), le signal suivant (Si+1) étant en retard de phase par rapport au signal courant (Si) de 360°/2^{q+1} ; caractérisé en ce que des moyens sont prévus pour synchroniser le signal de commutation (O) sur un front du signal d'entrée suivant (Si+1).

2. Multiplexeur selon la revendication 1, caractérisé en ce qu'il comprend :
- des premier et deuxième multiplexeurs (MUX1, MUX2) recevant respectivement les 2^{q} signaux d'entrée de rang impair ; et les 2^{q} signaux d'entrée de rang pair ;
- un troisième multiplexeur (MUX3) recevant sur les première et deuxième entrées les signaux de sortie des premier et deuxième multiplexeurs respectivement, et fournissant le signal de sortie du multiplexeur à 2^{q+1} entrées ;
- un quatrième multiplexeur (MUX4) recevant sur des première et deuxième entrées les signaux de sortie des deuxième et premier multiplexeurs respectivement ;
- une bascule (30) recevant sur une entrée de donnée ledit signal de commutation (O) par l'intermédiaire d'un diviseur par 2, recevant sur son entrée d'horloge la sortie du quatrième multiplexeur (MUX4), et fournissant le signal de sélection des troisième et quatrième multiplexeurs ; et
- des moyens de commande (32) des premier et deuxième multiplexeurs commutant la sélection du premier multiplexeur à chaque activation de rang impair du signal de commutation et commutant la sélection du deuxième multiplexeur à chaque activation de rang pair du signal de commutation.

## Patentansprüche

1. Multiplexer mit 2^{q+1} Eingängen, die gegeneinander phasenverschobene, periodische Signale (S1 bis S2^{q+1}) empfangen, der so gesteuert wird, daß er durch die Aktivierung eines Schaltsignals (O) von einem aktuellen Eingangssignal (Si) auf ein nächstes Eingangssignal (Si+1) schaltet, wobei das nächste Signal (Si+1) eine Phasenverzögerung hinsichtlich des aktuellen Signals (Si) von 360°/2^{q+1} aufweist, dadurch **gekennzeichnet**, daß eine Einrichtung vorgesehen ist, um das Schaltsignal (O) mit einer Flanke des nächsten Eingangssignals (Si+1) zu synchronisieren.

2. Der Multiplexer nach Anspruch 1, dadurch **gekennzeichnet**, daß er folgende Merkmale aufweist:
- einen ersten und einen zweiten Multiplexer (MUX1, MUX2), an dem die 2^{q} Eingangssignale ungerader Ordnung bzw. die 2^{q} Eingangssignale gerader Ordnung anliegen;
- einen dritten Multiplexer (MUX3), an dessen erstem und zweitem Eingang die Ausgangssignale des ersten und des zweiten Multiplexers anliegen und die das Ausgangssignal des Multiplexers mit 2^{q+1} Eingängen liefern;
- einen vierten Multiplexer (MUX4), an dessen erstem und zweitem Eingang die Ausgangssignale des zweiten und des ersten Multiplexers anliegen;
- einen Signalspeicher (30), der an einem Dateneingang das Schaltsignal (O) über einen Halbierer empfängt, an dessen Takteingang das Ausgangssignal des vierten Multiplexers (MUX4) anliegt und der das Auswahlsignal des dritten und des vierten Multiplexers liefert; und
- eine Vorrichtung (32) zum Steuern des ersten und des zweiten Multiplexers, welche den ersten Multiplexer bei jeder ungeraden Aktivierung des Schaltsignals schaltet und den zweiten Multiplexer bei jeder geraden Aktivierung des Schaltsignals schaltet.

## Claims

1. A multiplexer having 2^{q+1} inputs receiving periodical signals (S1-S2^{q+1}) out of phase ones to the others, that is controlled so as to switch from a current input signal (Si) to a next input signal (Si+1) further to activation of a switch signal (O), the next signal (Si+1) having a phase lag with respect to the current signal (Si) of 360°/2^{q+1}, characterized in that means are provided to synchronize the switching signal (O) with an edge of the next input signal (Si+1).

2. The multiplexer of claim 1, including:
- a first and a second multiplexer (MUX1, MUX2) respectively receiving the 2^{q} input signals of odd rank and the 2^{q} input signals of even rank;
- a third multiplexer (MUX3) receiving at first and second inputs the output signals of the first and second multiplexers, respectively, and providing the output signal of the multiplexer with 2^{q+1} inputs;
- a fourth multiplexer (MUX4) receiving at first and second inputs the output signals of the second and first multiplexers, respectively;
- a latch (30) receiving at a data input said switching signal (O) through a divider by 2, receiving at its clock input the output of the fourth multiplexer (MUX4), and providing the selection signal of the third and fourth multiplexers; and
- means (32) for controlling the first and the second multiplexer switching the selection of the first multiplexer at each odd activation of the switching signal, and switching the selection of the second multiplexer at each even activation of the switching signal.
